## Europäisches Patentamt

## European Patent Office

## Office européen des brevets

(11)  **EP 1 346 793 A1**

(19)

(12)  **EUROPÄISCHE PATENTANMELDUNG**

(43)  Veröffentlichungstag:
      **24.09.2003  Patentblatt 2003/39**

(51)  Int Cl.7: **B23K 20/00**, H01L 21/607,
      H01L 21/00

(21)  Anmeldenummer: **02006158.6**

(22)  Anmeldetag: **19.03.2002**

(84)  Benannte Vertragsstaaten:
      **AT BE CH CY DE DK ES FI FR GB GR IE IT LI LU
      MC NL PT SE TR**
      Benannte Erstreckungsstaaten:
      **AL LT LV MK RO SI**

(71)  Anmelder: **ESEC Trading S.A.**
      **6330 Cham (CH)**

(72)  Erfinder:
      • **Hess, Peter**
        **CH-6318 Walchwil (CH)**

      • **Michler, Markus**
        **AT-6800 Feldkirch (AT)**
      • **Onda, Nicolino**
        **CH-7310 Bad Ragaz (CH)**

(74)  Vertreter: **Falk, Urs, Dr.**
      **Patentanwaltsbüro Dr. Urs Falk,**
      **Eichholzweg 9A**
      **6312 Steinhausen (CH)**

(54)  **Verfahren und Einrichtung für die Bestimmung der vektoriellen Distanz zwischen der Kapillare und dem Bilderkennungssystem eines Wire Bonders**

(57)    Für die Bestimmung der vektoriellen Distanz D zwischen der Spitze einer Kapillare (5) und einer optischen Achse (8) eines Bilderkennungssystems eines Wire Bonders wird eine mit Licht gespeiste Glasfaser (10) als Referenzpunkt und als Sensor verwendet. Die Glasfaser (10) dient einerseits als Referenzpunkt, mit dem die Lage der optischen Achse (8) des Bilderken-nungssystems bestimmt werden kann. Andererseits dient die Glasfaser als Sensor, mit dem die Lage der Spitze der Kapillare (5) bestimmt werden kann, in dem festgestellt wird, in welcher Position des Bondkopfs (1) die Intensität des Lichts maximal wird, das von einer an der Spitze der Kapillare (5) gebildeten Drahtkugel (17) in die Glasfaser (10) zurückreflektiert wird.

Fig. 2

EP 1 346 793 A1

**Beschreibung**

Die Erfindung betrifft ein Verfahren für die Bestimmung der vektoriellen Distanz zwischen der Kapillare und dem Bilderkennungssystem eines Wire Bonders und einen Wire Bonder mit einer dazu geeigneten Einrichtung.

Ein Wire Bonder ist ein Automat, mit dem Halbleiterchips nach deren Montage auf einem Substrat verdrahtet werden. Der Wire Bonder weist eine Kapillare auf, die an der Spitze eines Horns eingespannt ist. Die Kapillare dient zum Befestigen des Drahtes auf einem Anschlusspunkt des Halbleiterchips und auf einem Anschlusspunkt des Substrates sowie zur Drahtführung zwischen den beiden Anschlusspunkten. Die Lage der Anschlusspunkte wird vor dem Bonden mittels eines Bilderkennungssystems bestimmt, so dass die Kapillare an der richtigen Stelle auf dem Anschlusspunkt aufsetzt. Ein Problem besteht nun darin, dass sich die Distanz zwischen der Kapillare und der optischen Achse des Bilderkennungssystems im Betrieb aufgrund thermischer Effekte auf unvorhersehbare Weise ändern kann. Die Distanz muss deshalb laufend nachgeeicht werden.

Der Erfindung liegt die Aufgabe zugrunde, ein Messsystem zu entwickeln, mit dem die Distanz zwischen der Kapillare und der optischen Achse des Bilderkennungssystems auf einfache und zuverlässige Weise bestimmt werden kann.

Die genannte Aufgabe wird erfindungsgemäss gelöst durch die Merkmale der Ansprüche 1 und 3.

Für die Bestimmung der vektoriellen Distanz D zwischen der Spitze einer Kapillare und einer optischen Achse eines Bilderkennungssystems eines Wire Bonders wird erfindungsgemäss eine mit Licht gespeiste Glasfaser als Referenzpunkt und als Sensor verwendet. Die Glasfaser dient einerseits als Referenzpunkt, mit dem die Lage der optischen Achse des Bilderkennungssystems bestimmt werden kann. Andererseits dient die Glasfaser als Sensor, mit dem die Lage der Spitze der Kapillare bestimmt werden kann, in dem festgestellt wird, in welcher Position des Bondkopfs die Intensität des Lichts maximal wird, das von einer an der Spitze der Kapillare gebildeten Drahtkugel in die Glasfaser zurückreflektiert wird. Die Bestimmung der vektoriellen Distanz D umfasst die folgenden Verfahrensschritte:

- Bildung einer Drahtkugel an der Spitze der Kapillare;
- Bewegung des Bondkopfes derart, dass die Kapillare über ein Ende der Glasfaser, deren anderes Ende von einer Lichtquelle mit Licht gespeist wird, bewegt wird, um erste Koordinaten zu bestimmen, die der Bondkopf einnehmen muss, damit die Intensität des von der Drahtkugel in die Glasfaser zurückreflektierten Lichts maximal ist;
- Bewegung des Bondkopfes, um das Ende der Glasfaser ins Blickfeld des Bilderkennungssystems zu bringen, und Bestimmung von zweiten Koordinaten, die der Bondkopf einnehmen muss, damit die optische Achse des Bilderkennungssystems das Zentrum der Glasfaser durchstösst; und
- Bestimmung der vektoriellen Distanz D aus den ersten und zweiten Koordinaten.

Nachfolgend wird ein Ausführungsbeispiel der Erfindung anhand der nicht massstäblich gezeichneten Figuren näher erläutert.

Es zeigen:

Fig. 1 in Aufsicht einen Bondkopf eines Wire Bonders, mit einer Kapillare, einem Bilderkennungssystem und einer Einrichtung für die Bestimmung der vektoriellen Distanz zwischen der Kapillare und der optischen Achse des Bilderkennungssystems, und

Fig. 2 die Einrichtung im Querschnitt.

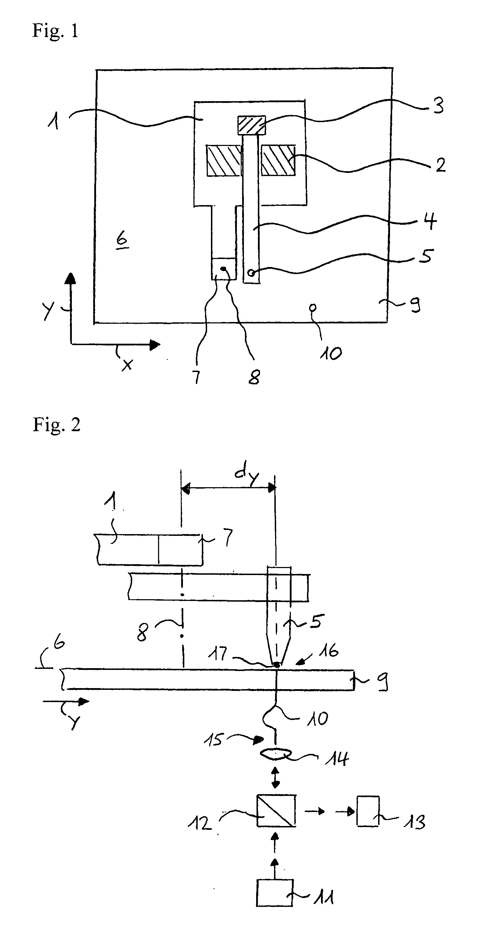

Die Fig. 1 zeigt schematisch und in Aufsicht einen Bondkopf 1 eines Wire Bonders. Der Bondkopf 1 umfasst eine um eine horizontale Achse drehbare Wippe 2. An der Wippe 2 ist ein von einem Ultraschallgeber 3 mit Ultraschall beaufschlagbares Horn 4 befestigt. An der Spitze des Horns 4 ist eine Kapillare 5 eingespannt. Die Kapillare 5 dient zum Befestigen eines Drahtes auf einem Anschlusspunkt eines Halbleiterchips und auf einem zugeordneten Anschlusspunkt eines Substrates sowie zur Drahtführung zwischen den beiden Anschlusspunkten. Der Bondkopf 1 ermöglicht die Bewegung der Kapillare 5 in einer durch die beiden Koordinatenachsen x und y aufgespannten Ebene 6, während die Wippe 2 die Bewegung senkrecht zur Ebene 6 ermöglicht. Der Wire Bonder weist weiter ein Bilderkennungssystem auf, dessen Blickfeld auf die Ebene 6 gerichtet ist und das dazu dient, die Lage der Anschlusspunkte auf dem Halbleiterchip und dem Substrat auszumessen. Das Bilderkennungssystem umfasst eine Kamera 7 und ein Bildauswertungssystem. Das Bilderkennungssystem weist eine optische Achse 8 auf, die senkrecht zur Ebene 6 verläuft. Im dargestellten Beispiel ist die Kamera 7 am Bondkopf 1 befestigt und ihr Blickfeld ist direkt auf die Ebene 6 gerichtet. Im Beispiel fällt die optische Achse 8 des Bilderkennungssystems mit der optischen Achse der Kamera 7 zusammen. Es kann aber erforderlich oder gewünscht sein, zusätzliche optische Komponenten wie Linsen, Spiegel, Prismen, etc. zu verwenden, um den Strahlengang zu führen und/oder um die Grösse des Blickfelds des Bilderkennungssystems verändern zu können.

Der Bondkopf 1 gleitet beispielsweise auf einem mit Vakuum vorgespannten Luftlager auf einer Gleitplatte 9.

Aus der EP 317 787 ist ein derartiger Bondkopf 1 bekannt, der mittels zweier elektromagnetischer Antriebe in x- bzw. y-Richtung bewegbar ist. Aus der EP 1 098 356 ist ein weiterer derartiger Bondkopf 1 bekannt, der aber einen linearen und einen rotativen Antrieb aufweist, um die Kapillare 5 in der Ebene 6 zu bewegen. Bekannt ist aber auch, den Bondkopf 1 mittels eines xy-Tisches zu bewegen. Die Position des Bondkopfs 1 in der Ebene 6 wird in bekannter Weise mittels eines Messsystems, beispielsweise eines optischen Messsystems, erfasst.

Die Erfindung wird am Beispiel kartesischer xy Koordinaten erläutert. Damit die Kapillare 5 auf dem jeweiligen Anschlusspunkt am richtigen Ort abgesetzt werden kann, werden zunächst mittels des Bilderkennungssystems diejenigen Koordinaten $(x_1, y_1)$ bestimmt, die der Bondkopf 1 einnehmen müsste, damit die optische Achse 8 des Bilderkennungssystems den gewünschten Auftreffpunkt der Kapillare 5 auf dem Anschlusspunkt durchstösst. Die Koordinaten $(x_2, y_2)$, die der Bondkopf 1 einnehmen muss, damit die Spitze der Kapillare 5 auf den gewünschten Auftreffpunkt auftrifft, ergeben sich aus diesen Koordinaten $(x_1, y_1)$ durch Addition eines Vektors $D=(d_X, d_Y)$, wobei der Vektor D die vektorielle Distanz zwischen der Spitze der Kapillare 5 und der optischen Achse 8 des Bilderkennungssystems bezeichnet: $(x_2, y_2) = (x_1, y_1) + (d_X, d_Y)$.

Die vektorielle Distanz D kann während des Produktionsbetriebes in unvorhersehbarer Weise variieren. Es ist deshalb nötig, die vektorielle Distanz D immer wieder nachzueichen. Da sich die Kapillare 5 ausserhalb des Blickfeldes des Bilderkennungssystems befindet, kann die Lage der Spitze der Kapillare 5 mit dem Bilderkennungssystem nicht direkt bestimmt werden. Für die Bestimmung des Vektors $D = (d_X, d_Y)$ ist deshalb erfindungsgemäss eine Einrichtung vorgesehen, die eine lichtleitende Glasfaser 10 umfasst, mittels derer sowohl Koordinaten $(x_A, y_A)$ der optischen Achse 8 des Bilderkennungssystems als auch Koordinaten $(x_C, y_C)$ der Spitze der Kapillare 5 bestimmt werden können.

Die Fig. 2 zeigt die Einrichtung im Querschnitt. Die Einrichtung besteht im wesentlichen aus der Glasfaser 10, einer Lichtquelle 11, einem Strahlteiler 12 und einem Lichtempfänger 13. Die Glasfaser 10 leitet Licht in beiden Richtungen. Das von der Lichtquelle 11 abgestrahlte Licht wird mittels eines optischen Systems, das mindestens eine Linse 14 umfasst, in ein Ende 15 der Glasfaser 10 eingespeist. Die Glasfaser 10 ist so angeordnet, dass der am anderen Ende 16 aus der Glasfaser 10 austretende Lichtstrahl orthogonal zur Ebene 6 verläuft. Wenn sich die Kapillare 5, an deren Spitze der Draht zu einer Kugel 17, dem sogenannten free air ball, geformt wurde, oberhalb der Glasfaser 10 befindet, dann reflektiert die Drahtkugel 17 einen Teil des aus der Glasfaser 10 austretenden Lichts in die Glasfaser 10 zurück. Der zwischen der Lichtquelle 11 und dem Ende 15 der Glasfaser 10 angeordnete Strahlteiler 12 dient dazu, das zurückreflektierte Licht räumlich von dem von der Lichtquelle 11 eingespeisten Licht zu trennen, so dass die Intensität des zurückreflektierten Lichts mittels des Lichtempfängers 13 gemessen werden kann. Mit Pfeilen ist die Richtung des Lichts dargestellt. Der optische Wirkungsgrad der Einrichtung ist am grössten, wenn der Strahlteiler 12 50% des auftreffenden Lichtes durchlässt und 50% des auftreffenden Lichtes reflektiert. Wenn das Licht der Lichtquelle 11 und die Empfindlichkeit des Lichtempfängers 13 ausreichend gross sind, dann kann als Strahlteiler 12 eine herkömmliche Glasplatte dienen, die unter einem Winkel von 45° angeordnet ist. Das Verhältnis von durchgelassenem zu reflektiertem Licht liegt bei einer Glasplatte bekanntlich bei rund 4%. Die Lichtausbeute ist bei Verwendung einer herkömmlichen Glasplatte somit nur um etwa den Faktor 6.5 geringer als bei einem 50:50 Strahlteiler. Um den Wirkungsgrad des Messsystems zu steigern, werden die Lichtquelle 11 bevorzugt entweder moduliert oder intermittierend mit Pulsen betrieben und der Lichtempfänger 13 entsprechend synchronisiert.

Als Glasfaser 10 wird z.B. eine Single Mode Fiber verwendet, deren Coredurchmesser nur etwa 4.5 μm beträgt. Da die Oberfläche der Drahtkugel 17 rund ist, wird genau dann am meisten Licht in die Glasfaser 10 zurückreflektiert, wenn sich das Zentrum der Drahtkugel 17 oberhalb der Glasfaser 10 befindet. Aus diesem Grund wird die Drahtkugel 17 während der Messung möglichst nahe an der Glasfaser 10 vorbeigeführt. Das Ende 16 der Glasfaser 10 ist bevorzugt bündig mit der Oberfläche der Gleitplatte 9.

Die Bestimmung des Vektors $D=(d_X, d_Y)$ erfolgt gemäss den folgenden Schritten:

1. An der Spitze der Kapillare 5 wird eine Drahtkugel 17 geformt.

2. Der Bondkopf 1 bewegt die Kapillare 5 über das Ende der Glasfaser 10. Die Koordinaten (x, y) des Bondkopfs 1 und die Intensität I(x, y) des zurückreflektierten Lichts werden dabei laufend gemessen und gespeichert. Anschliessend werden aus der Intensitätsverteilung I(x, y) diejenigen Koordinaten $(x_C, y_C)$ bestimmt, die der Bondkopf 1 einnehmen müsste, damit die Intensität I des zurückreflektierten Lichts maximal ist.

3. Der Bondkopf 1 wird bewegt, bis sich die Glasfaser 10 im Blickfeld des Bilderkennungssystems befindet. In dem von der Kamera 7 gelieferten Bild erscheint nun das Core der Glasfaser 10 als Kreisfläche, die sich vom sie umgebenden, restlichen Teil der Glasfaser deutlich unterscheidet. Aus dem von der Kamera 7 gelieferten Bild werden nun diejenigen Koordinaten $(x_A, y_A)$ des Bondkopfs 1 bestimmt, die der Bondkopf 1 einnehmen müsste, damit die optische Achse 8 des Bilderkennungssystems das Zentrum des Cores der Glasfaser 10 durchstösst.

4. Der Vektor D kann nun berechnet werden zu:

$$D=(d_X, d_Y) = (x_C, y_C) - (x_A, y_A), \text{d.h. } d_X = x_C - x_A \text{ und } d_Y = y_C - y_A.$$

Die Bestimmung der Koordinaten $(x_C, y_C)$ im Schritt 2 kann beispielsweise erfolgen, in dem der Bondkopf 1 in vorbestimmten Schritten $\Delta x$ und $\Delta y$ die Glasfaser 10 abscannt, wobei bei jedem Schritt die Koordinaten des Bondkopfs und das Ausgangssignal I des Lichtempfängers 13 erfasst werden, und wobei die Koordinaten $(x_C, y_C)$ anschliessend durch Bestimmung der Lage des Maximums aus den Messwerten ermittelt werden.

Die Bestimmung der Koordinaten $(x_A, y_A)$ im Schritt 3 erfolgt vorzugsweise, ohne dass die Glasfaser 10 von der Lichtquelle 11 mit Licht gespeist wird, d.h. mit ausgeschalteter Lichtquelle 11.

Da es sich empfiehlt, die Eichung der Distanz D in regelmässigen Abständen durchzuführen, ist das Messsystem bevorzugt fest auf dem Wire Bonder installiert.

Das neue Eichverfahren wurde für das Beispiel eines Bondkopfes beschrieben, der mittels zweier in x-bzw. in y-Richtung gerichteter Antriebe innerhalb der xy-Ebene bewegt wird. Das Eichverfahren kann auf analoge Art auch bei einem rotativen Bondkopf verwendet werden. Bei einem rotativen Bondkopf werden anstelle der kartesischen Koordinaten x und y andere Koordinaten verwendet, wobei sich dann die Berechnung der vektoriellen Distanz D anders gestaltet.

Die im Beispiel beschriebene Einrichtung ist aus herkömmlichen optischen Komponenten - Glasfaser 10, Strahlteiler 12, Linse 14 - gebildet. Möglich ist auch eine komplett faseroptische Lösung, bei der Glasfaser und Strahlteiler ein einziges faseroptisches Bauteil sind. Als Lichtquelle 11 kann z.B. eine sogenannte Pigtaildiode an das faseroptische Bauteil angeschlossen werden, wobei dann die Linse 14 entfällt.

**Patentansprüche**

1. Wire Bonder mit einer Einrichtung für die Bestimmung der vektoriellen Distanz zwischen der Spitze einer Kapillare (5) und einer optischen Achse (8) eines Bilderkennungssystems (7) des Wire Bonders, wobei die Einrichtung eine Glasfaser (10), eine Lichtquelle (11) zur Einspeisung von Licht in die Glasfaser (10), einen Strahlteiler (12) und einen Lichtempfänger (13) umfasst.

2. Wire Bonder nach Anspruch 1, **dadurch gekennzeichnet, dass** die Glasfaser (10) und der Strahlteiler (12) ein einziges, faseroptisches Bauteil sind.

3. Verfahren für die Bestimmung der vektoriellen Distanz D zwischen der Spitze einer Kapillare (5) und einer optischen Achse (8) eines Bilderkennungssystems (7) eines Wire Bonders, wobei die Kapillare (5) und die optische Achse (8) des Bilderkennungssystems (7) mittels eines Bondkopfes (1) gemeinsam in einer Ebene bewegbar sind, das die folgenden Schritte umfasst:

   - Bildung einer Drahtkugel (17) an der Spitze der Kapillare (5);
   - Bewegung des Bondkopfes (1) derart, dass die Kapillare (5) über ein Ende einer Glasfaser (10), deren anderes Ende von einer Lichtquelle (11) mit Licht gespeist wird, bewegt wird, um erste Koordinaten zu bestimmen, die der Bondkopf (1) einnehmen muss, damit die Intensität des von der Drahtkugel (17) in die Glasfaser (10) zurückreflektierten Lichts maximal ist;
   - Bewegung des Bondkopfes (1), um das Ende der Glasfaser (10) ins Blickfeld des Bilderkennungssystems zu bringen, und Bestimmung von zweiten Koordinaten, die der Bondkopf (1) einnehmen muss, damit die optische Achse (8) des Bilderkennungssystems das Zentrum der Glasfaser (10) durchstösst; und
   - Bestimmung der vektoriellen Distanz D aus den ersten und zweiten Koordinaten.

4. Verfahren nach Anspruch 3, **dadurch gekennzeichnet, dass** die Lichtquelle für die Bestimmung der zweiten Koordinaten ausgeschaltet ist.

Fig. 1

Fig. 2

**Europäisches Patentamt**

# EUROPÄISCHER RECHERCHENBERICHT

Nummer der Anmeldung

EP 02 00 6158

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 2001/011669 A1 (ENOKIDO SATOSHI ET AL) 9. August 2001 (2001-08-09) | 1,2 | B23K20/00 H01L21/607 |
| A | * das ganze Dokument * | 3,4 | H01L21/00 |
| | --- | | |
| X | PATENT ABSTRACTS OF JAPAN vol. 2000, no. 04, 31. August 2000 (2000-08-31) -& JP 2000 021923 A (SHINKAWA LTD), 21. Januar 2000 (2000-01-21) | 1,2 | |
| A | * Zusammenfassung * | 3,4 | |
| | --- | | |
| A | US 5 037 023 A (AKIYAMA YUKIHARU ET AL) 6. August 1991 (1991-08-06) * Spalte 9, Zeile 8 - Zeile 26 * | 1-4 | |
| | --- | | |
| A | US 4 855 928 A (YAMANAKA KAZUYUKI) 8. August 1989 (1989-08-08) * Spalte 2, Zeile 10 - Zeile 48 * * Zusammenfassung; Abbildungen * | 1-4 | |
| | ----- | | |

RECHERCHIERTE SACHGEBIETE (Int.Cl.7)

B23K
H01L

Der vorliegende Recherchenbericht wurde für alle Patentansprüche erstellt

| Recherchenort | Abschlußdatum der Recherche | Prüfer |
|---|---|---|
| DEN HAAG | 5. Juli 2002 | Haegeman, M |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 02 00 6158

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-07-2002

| Im Recherchenbericht angeführtes Patentdokument | Datum der Veröffentlichung | Mitglied(er) der Patentfamilie | Datum der Veröffentlichung |
|---|---|---|---|
| US 2001011669 A1 | 09-08-2001 | JP 2001203234 A | 27-07-2001 |
| JP 2000021923 A | 21-01-2000 | JP 2982000 B2 | 22-11-1999 |
| | | TW 419759 B | 21-01-2001 |
| US 5037023 A | 06-08-1991 | JP 2213146 A | 24-08-1990 |
| | | JP 2723280 B2 | 09-03-1998 |
| | | JP 2146742 A | 05-06-1990 |
| | | JP 2541645 B2 | 09-10-1996 |
| | | US 5110032 A | 05-05-1992 |
| | | US 5176310 A | 05-01-1993 |
| | | KR 155153 B1 | 01-12-1998 |
| US 4855928 A | 08-08-1989 | JP 1767645 C | 11-06-1993 |
| | | JP 4053094 B | 25-08-1992 |
| | | JP 63062242 A | 18-03-1988 |
| | | DE 3785129 D1 | 06-05-1993 |
| | | DE 3785129 T2 | 15-07-1993 |
| | | EP 0262777 A2 | 06-04-1988 |
| | | KR 9007688 B1 | 18-10-1990 |

Für nähere Einzelheiten zu diesem Anhang : siehe Amtsblatt des Europäischen Patentamts, Nr. 12/82